# EUROPEAN PATENT SPECIFICATION

(11) **EP 3 574 528 B1**
(45) Date of publication and mention of the grant of the patent: **13.03.2024**
(21) Application number: 18711714.8
(22) Date of filing: 24.01.2018
(51) Int. Cl.: H01L 31/0224, H01L 31/0392, H10K 102/10, H10K 30/82, H10K 50/816

(54) **OPTOELECTRONIC FOIL AND MANUFACTURING METHOD OF OPTOELECTRONIC FOIL**
OPTOELEKTRONISCHE FOLIE UND VERFAHREN ZUR HERSTELLUNG EINER OPTOELEKTRONISCHEN FOLIE
FEUILLE OPTOÉLECTRONIQUE ET PROCÉDÉ DE FABRICATION DE FEUILLE OPTOÉLECTRONIQUE

(30) Priority: 25.01.2017 PL 42030017
(43) Date of publication of application: 04.12.2019
(73) Proprietor: Saule Spolka Akcyjna, 54-427 Wroclaw (PL)
(72) Inventor: WOJCIECHOWSKI, Konrad, 53-512 Wroclaw (PL); MALINKIEWICZ, Olga, 00-732 Warszawa (PL); BURSA, Bartosz, 64-300 Nowy Tomysl (PL); PRIETO RUIZ, Juan Pablo, 46-980 Paterna Valencia (ES); WILK, Barbara, 50-217 Wroclaw (PL); KUPCZUNAS, Artur, 62-800 Kalisz (PL)
(74) Representative: Kancelaria Eupatent.pl Sp. z.o.o
(86) International application number: PCT/PL2018/000008
(87) International publication number: WO 2018/139945

(56) References cited:
- EP-A1- 2 871 681
- EP-A2- 2 720 276
- US-A1- 2014 054 578

## Description

The present invention relates to an optoelectronic foil and a method for the production thereof.

In terms of design, the optoelectronic foil consists of a flexible polymer foil substrate and a transparent electrode. It is the basis for the construction of a wide array of optoelectronic devices that are produced on said foils using a variety of techniques. Optoelectronic devices, for the construction of which optoelectronic foils are used, include flexible emission displays (OLED, QD LCD), flexible photovoltaic devices, touch screen sensors, flexible random access memory (RAM) and gas sensors.

The disadvantage of optoelectronic flexible foils lies in the poor tightness of the flexible substrate constituted by polymer foils with a high oxygen and water permeability coefficient, which result in the short lifespan of optoelectronic devices. Especially devices containing organic materials in active layers, for example OLEDs (Organic Light Emitting Diodes) are sensitive to weather conditions. Moisture and oxygen penetration from the air cause the degradation of the active material, which, as a result, precludes the optoelectronic device from operating.

Various technologies are known for the production of protective layers in the structure of optoelectronic foils designed to extend the lifespan of optoelectronic devices, including:
- "Dam-and-fill" encapsulation technique. During this process, a high viscosity fluid is distributed, forming a rectangular barrier around the device (e.g. an OLED). Said fluid is distributed during the droplet application process so as to fill the space between the substrate and the barrier film within the barrier. This method is characterized by simplicity and high stability;
- technique of sealing using a thin multi-layer foil, i.e. "thin-film-encapsulation" (TFE). The most common TFE technologies include plasma-enhanced chemical vapor deposition (PECVD) and atomic layer deposition (ALD);
- Plasma-enhanced chemical vapor deposition (PECVD) involves preparation of an inorganic-and-inorganic or organic-and-organic barrier, with the process typically using silicon nitride or silicon dioxide; the advantage of this technique lies in the low temperature process (below 600°C), and the possibility of deposition of nonequilibrium phases, as well as the relatively high purity of the resulting coatings;
- atomic layer deposition technique, (ALD), which involves depositing a barrier film; this technique uses e.g. aluminium oxides and nitrides for deposition; the advantage of this method is that it allows for obtaining coatings characterised by relatively good tightness.

Moreover, some techniques that are known for improving barrier characteristics and general sealing of a FOLED (Flexible Organic Light Emitting Diode) display, involve using ultra-thin metal or glass foils. The advantage of this type of solutions is the achievement of foils with good gas permeability properties, while it is their disadvantage that the foils obtained are matte, opaque and easily damaged.

Further, patent literature discloses structures of conductive materials used for the construction of optoelectronic devices.

International patent application WO2015/179834A1 discloses a structure of a conductive film consisting of silver (Ag) in an amount of no less than 80% of the total atomic content of the conductive film and a conductive metal selected from the group consisting of: Al, Ti, Ni, Cr, Au, Mg, Ta, Ge in an amount of no more than 20% of the total atomic content of the conductive film. The manufacturing process of the electrically conductive layer comprises the co-deposition of gold, copper and a conductive metal on a substrate to form a continuous conductive film. WO2015/179834A1, however, does not provide information on the method for preparing a barrier layer to limit the moisture or oxygen penetration into the conductive film. Examples of structures disclosing a substrate, a barrier layer and a conductive layer are disclosed in patent publications EP2871681A1 and US2014/054578A1.

Therefore, it is desirable to provide a flexible optoelectronic foil structure with improved barrier properties against particles of gas and water vapour, which would allow for the manufacture of optoelectronic devices with an extended lifespan without deterioration of the transparency of the entire foil material. It is also desirable to provide the optoelectronic foil, which would be useful for both, passive devices incorporating barrier solutions and active optoelectronic devices including flexible, transparent electrodes.

The invention relates to an optoelectronic foil and a method for manufacturing an optoelectronic foil according to the appended claims.

An embodiment of the present invention will now be described by way of example with reference to the accompanying drawings, wherein:
Fig. 1 schematically shows a cross-section of the structure of an optoelectronic foil according to one embodiment of the present invention;
Fig. 2 shows a flowchart of the optoelectronic foil manufacturing process, and
Fig. 3 schematically shows a cross-section of the structure of an optoelectronic foil according to another embodiment of the present invention.

The optoelectronic foil according to the invention has a transparency of no less than 50% and is characterised by low water vapor permeability, as the water vapor transmission rate (WVTR) of the optoelectronic foil 10 is between 10⁻³ and 10⁻⁶ g/m² per day. Due to optoelectronic properties and high transparency, the foil can be used for the manufacture of various devices, including, but not limited to, devices from the field of imaging optoelectronics and photovoltaic optoelectronics. For example, the foil can be used for the manufacture of flexible OLED or QD LCD displays, in photovoltaic systems, including, but not limited to, ultra-thin, transparent photovoltaic cells that can be placed on window panes, computer screens, mobile phones, clothing parts, and other everyday use items. Due to improved barrier properties and improved lifespan, the foil can also be used in the automotive or construction industry.

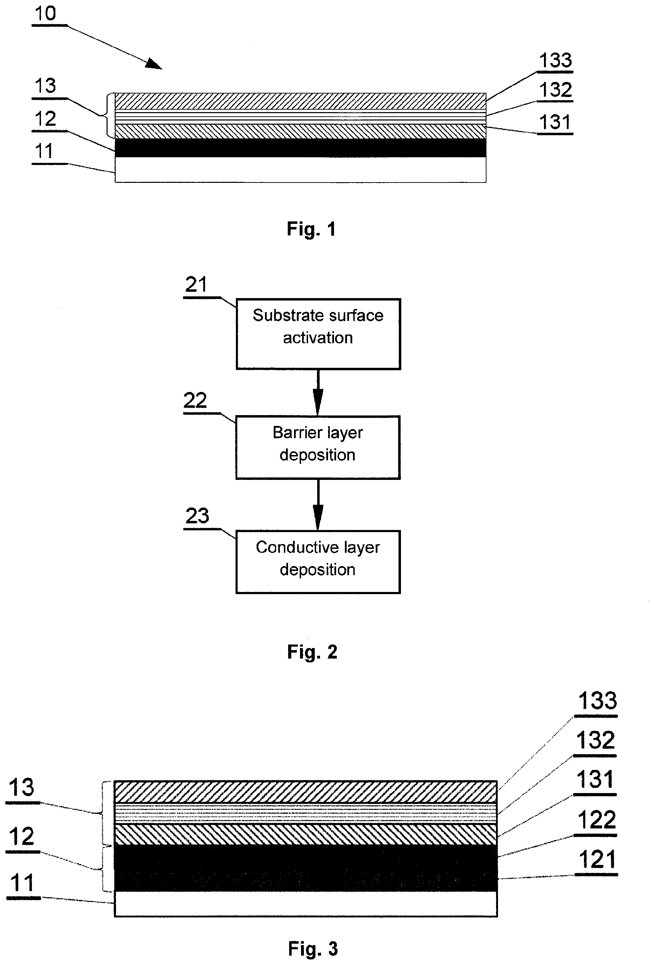

Fig. 1 schematically illustrates the optoelectronic foil in a cross-section, showing the layered foil construction.
The optoelectronic foil has a substrate 11 with a barrier layer 12 on which a conductive layer 13 comprising at least one oxide layer 131 and at least one metal layer 132 is deposited.

The substrate 11 of the optoelectronic foil 10 may be made of a variety of transparent substrate materials selected from the group consisting of plastics and/or plastics with nanocomposites of inorganic materials. For example, plastics for the substrate 11 may be provided in the form of at least one type of material selected from the group consisting of polyethylene terephthalate (PET), polyethylene naphthalene (PEN), polyethylene (PE), polypropylene (PP), polyethersulfone (PES), polyimide (PI), polystyrene (PS), ethylene/tetrafluoroethylene (ETFE) and polymers evaporated onto the surface from the group of poly-p-xylenes collectively referred to as parylene.

The barrier layer 12 of the foil 10 has a barrier function and prevents against moisture and oxygen penetration from the substrate 11 into the conductive layer 13, thus ensuring a significant reduction of degradation processes of the conductive layer that constitutes the optoelectronic element of the foil 10 and of the active layers of the device that can be deposited onto the optoelectronic foil 10.

The barrier layer 12 consists of at least one material selected from the group consisting of silicon oxides (SiOₓ), aluminium oxides (Al₂O₃, AlOₓN_{y}), titanium oxides (TiOₓ), silicon oxynitrides SiON, silicon nitrides (Si₃N₄, SiNₓ), organic silicon compounds (SiCₓH_{y}), zirconium oxide (ZrO₂), hafnium oxide (HfO₂), chromium oxides (CrO, Cr₂O₃, CrO₂, CrO₃, CrO₅) and parylene. More preferably, the barrier layer may consist of at least two different materials selected from the group consisting of silicon oxides (SiOₓ), aluminium oxides (Al₂O₃, AlOₓN_{y}), titanium oxides (TiOₓ), silicon oxynitride SiON, silicon nitrides (Si₃N₄, SiNₓ), organic silicon compounds (SiCₓH_{y}), zirconium oxide (ZrO₂), hafnium oxide (HfO₂), chromium oxides (CrO, Cr₂O₃, CrO₂, CrO₃, CrO₅) and parylene.

In one embodiment, the barrier layer may take, for example, the form of a monolayer consisting of only one material, such as Al₂O₃. In another embodiment, the barrier layer may take the form of a monolayer comprising at least two different materials and may be made, for example, of Al₂O₃ doped with TiO₂. In yet another embodiment, the barrier layer 12 may consist of at least two different materials, and it may take the form of a multi-layer comprising, within the barrier layer 12, at least two sub-layers stacked one on the other, wherein each sub-layer may be made of different material or materials. For example, the barrier layer may have two sublayers, where one sublayer is made of Al₂O₃, and the other sublayer is made of TiO₂. Each sublayer within the barrier layer 12 may be of the same or different thickness, preferably in the range between 5 and 500 nm, regardless of the thickness of another sublayer.

Preferably, the barrier layer 12 may comprise two sublayers, each made of a different material, selected from the group of materials listed above. The barrier layer 12 may have a total thickness preferably in the range between 5 and 1000 nm.

The conductive layer 13 is an optoelectronic active layer of the foil with conductive properties. The conductive layer 13 comprises at least one oxide layer 131, 133 and at least one metal layer 132 stacked one on the other.

Moreover, as shown in Fig. 1, the conductive layer comprises at least two oxide layers 131 and 133, or more than two oxide layers, separated by metal layers 132 to form a sandwich architecture. All layers 131, 132, 133 are stacked in the conductive layer 13 one on the other, substantially in parallel.

In each embodiment of the conductive layer 13, comprising more than one, for example two oxide layers 131, 133, the oxide layer 131, 133 is made of at least one oxide selected from the group consisting of: ZnO, AZO (aluminium zinc oxide), SnO₂, IZO (indium zinc oxide), FTO (fluorine tin oxide), ZTO (tin zinc oxide), ITO (tin indium oxide), GZO (zinc gallium oxide), GIO (indium gallium oxide), In₂O₃, Sb:SnO₂, IO:H (hydrogen indium oxide), CdO, Zn₂SnO₄, ZnSnO₃, Zn₂In₂O₅, NiOₓ, NiOₓ:Li, TiOₓ, ZnS, ZnSe, Te₂O₃, MoOₓ, V₂O₅ and WO₃. In each embodiment of the conductive layer 13 of the optoelectronic foil 10, the oxide layer 131, 133 may preferably have a thickness in the range between 15 and 150 nm.

In one embodiment, the oxide layer 131, 133 may take the form of a monolayer and consist of one type of oxide, from the group of oxides listed above, for example ZnO. In another embodiment, the oxide layer may take the form of a monolayer and consist of more than one material, for example the oxide layer 131, 133, in the form of a monolayer may be made of ZnO doped with Al. In yet another embodiment, the oxide layer 131, 133 may consist of at least two different oxides and may take the form of a multilayer comprising, within one oxide layer 131, 133, at least two sublayers, wherein each sublayer is made of a different oxide material comprising at least one oxide. For example, the oxide layer 131, 133 may consist of two sublayers stacked one on the other within one oxide layer 131, 133, wherein one sublayer is made of ZnO and the other sublayer is made of AZO or IZTO doped with Al.

Depending on the intended use and the required parameters, the optoelectronic foil may comprise at least two oxide layers 131, 133, wherein one oxide layer takes the form of a monolayer and another oxide layer takes the form of a multilayer comprising at least two sublayers made of different oxide materials. Moreover, in each embodiment of the conductive layer 13 comprising more than one oxide layer, the metal layer 132 is made of at least one metal selected from the group consisting of: Al, Ti, Ni, Cr, Au, Mg, Ta, Ge, Ag, Cu, Zr, Pt and W. For each embodiment of the conductive layer 13 of the optoelectronic foil 10, the metal layer 132 may preferably have a thickness in the range between 2 and 20 nm.

Depending on the target utility parameters of the optoelectronic foil, the conductive layer 13 may comprise, as schematically shown in Fig. 1, two oxide layers 131, 133, each of which may be a multi- or monolayer, and one metal layer 132 separating the two oxide layers. In another embodiment, the conductive layer 13 may have three oxide layers and two metal layers stacked within the conductive layer one alternately on the other, so that each of the metal layers separates the two adjacent oxide layers. In yet another embodiment, the conductive layer may have n oxide layers 131, 133, each of which may be a multi- or monolayer, and n-1 metal layers stacked one on the other, so that each metal layer 132 separates two adjacent oxide layers 132, 133 forming a sandwich structure, where n is any number selected from the set of natural numbers. For example, n may be 2, 3, 4, 5, 6 or 7. For example, n may be up to 33, or n may be more than 33.

Fig. 2 schematically shows a manufacturing method of the optoelectronic foil.

A substrate material 11 is prepared in order to produce the optoelectronic foil in step 21. The preparation process involves thorough cleaning and activation of the selected substrate surface. The cleaning and activation process of step 21 is implemented using at least one technique selected from the group consisting of plasma treatment, corona discharge treatment, carbon dioxide treatment, cleaning with solvents such as acetone, isopropanol, water, or mixtures of acetone and water or a mixture of isopropanol and water, as well as surface treatment with ultraviolet (UV) radiation and ozone.

Then, in step 22, a barrier layer 12 is deposited onto the cleaned and activated surface of the substrate 11.

Depending on the structure of the barrier layer 12, step 22 may include one or more steps. For example, in order to form a barrier layer having a monolayer structure and made of at least one type of material, for example Al₂O₃, or Al₂O₃ doped with TiO₂, in step 22 the barrier layer may be deposited in one step. However, in order to form a barrier layer with a multilayer structure comprising at least two sublayers made of different materials, the deposition step 22 may comprise several sub-steps, each involving depositing one sublayer onto the barrier layer 12. For example, to form a barrier layer comprising two sublayers, the deposition in step 22 is implemented so that a sublayer of one material is deposited in the first step, and then a sublayer of another material selected from the material group for the barrier layer 12 listed above is deposited. The processes of depositing the barrier layer 12 having both the structure of a multilayer and monolayer may be implemented using at least one known deposition technique selected from the group consisting of: atomic layer deposition (ALD) technique, magnetron sputtering technique, electron-beam sputtering technique and thermal evaporation technique.

Then, in step 23, a conductive layer 13 is deposited onto the barrier layer having a multi- or monolayer structure, wherein each of the sublayers of the conductive layer 13, that is at least two oxide layers 131, 132 and at least one metal layer 132, is deposited onto the barrier layer 12 individually, in order to obtain the appropriate functionality and architecture of the conductive layer 13, e.g. a sandwich architecture. Each of the sublayers 131, 132, 133 of the conductive layer can be deposited using various deposition methods also known from the art, selected from the group consisting of: atomic layer deposition (ALD) technique, magnetron sputtering, electron-beam sputtering technique and thermal evaporation technique.

For example, the conductive layer 13 having the architecture, as shown in Fig. 1, comprising two oxide layers 131, 133 and a metal layer 132 between the oxide layers, is deposited in step 23 so that in the first step, the first oxide layer 131 is deposited directly onto the surface of the barrier layer 12, then a metal layer 132 is deposited onto the first oxide layer, and then a second oxide layer 133 is deposited onto the metal layer 132. Each of the sub-layers 131, 132, 133 may be deposited using the same or different deposition techniques.

Furthermore, depending on the target structure of the oxide layers 131, 133, each of which may take the form of a monolayer or a multilayer, the oxide layer 131, 133 may be deposited in step 23 in single step or several steps, each of which may be implemented using one technique as well as different deposition techniques. For example, for an oxide layer 131, 132 having a monolayer structure made of an oxide material containing one type of oxide, for example: Al₂O₃, or an oxide material containing two types of oxides, for example Al₂O₃ doped with TiO₂, the oxide layer 131, 133 may be deposited in single step 23. Now, in order to form the oxide layer 131, 133 having a multilayer structure consisting of at least two sublayers stacked one on the other, the oxide layer may be deposited in several steps in step 23, each step including depositing one sublayer within the oxide layer 131, 133.

The optoelectronic foil obtained combines barrier properties and an efficient conductive layer 13, which preferably may have the architecture of an electrode, depending on the materials used as the materials for oxide and metal layers 131, 132, 133, respectively. In each embodiment of the foil 10, the conductive layer 13 is integrated with an flexible substrate 11, 12 having barrier properties.

The barrier layer of the optoelectronic foil has water vapor permeability rates (WVTR) ranging between 10⁻³ and 10⁻⁶ g/m² per day and has stable barrier properties, including high hydrophobicity and UV radiation resistance, which improves the lifespan of the conductive layer of the foil according to the present invention.

Moreover, the optoelectronic foil is flexible and is characterised by relatively high transparency, while the conductive layer of the foil has good conductivity and is an alternative to the single, thicker conductive ITO (indium tin oxide) layer known in the prior art that is relatively brittle, has limited conductivity and is expensive.

### Example 1

The optoelectronic foil according to one embodiment of the present invention is schematically shown as a cross-section in Fig. 1. The optoelectronic foil comprises a substrate 11, which in this embodiment is made of a plastic, namely polyethylene terephthalate (PET). The top surface of substrate 11 was cleaned and activated using oxygen plasma treatment. Then, a single barrier layer 12 made of AlOₓ with a thickness of 300 nm, which is an amorphous layer, was deposited onto the top surface of substrate 11 thus prepared in the reactive magnetron sputtering process. Next, a conductive layer 13 was deposited onto the barrier layer 12 in the reactive magnetron sputtering process, comprising the first oxide layer 131 made of ITO with a thickness of 20 nm, a metal layer 132 made of Ag with a thickness of 9 nm and a second oxide layer 133 made of ITO with a thickness of 20 nm. The optoelectronic foil thus obtained was subjected to tests involving a measurement of surface resistance by means of a four-point probe, a WVTR permeability measurement by means of a calcium test (measurement conditions RH=40%, T = 25°C) and measurement of light transmission in the visible spectrum using a UV-Vis spectrophotometer. The tests conducted yielded a surface resistance of the conductive layer 13 of 12 Ω/□, a WVTR permeability rate of 10⁻³ g/m² per day and light transmission in the visible spectrum in the range of 70-78%.

The use of a three-layer electrode structure (conductive layer 13), where the two oxide layers 131, 133 are separated by a thin metal layer 132, provided high flexibility to the conductive layer 13 (due to the presence of the metal layer 12), and, as a result, to the entire optoelectronic foil, together with high conductivity are ensured, as demonstrated in the tests described above.

### Example 2

The optoelectronic foil according to another embodiment of the present invention is schematically shown as a cross-section in Fig. 3. The optoelectronic foil comprises a substrate 11, which in this embodiment is made of a plastic, namely polyethylene terephthalate (PET). The top surface of substrate 11 was cleaned and activated using oxygen plasma treatment. Then, a barrier layer 12 in the form of an AlOₓ layer 121 with a thickness of 100 nm and a TiOₓ layer 122 with a thickness of 150 nm, which constitute amorphous layers, were deposited onto the top surface of substrate 11 thus prepared in the reactive magnetron sputtering process. Next, a conductive layer 13 was deposited onto the barrier layer 12 in the reactive magnetron sputtering process, containing the first oxide layer 131 made of ITO with a thickness of 20 nm, a metal layer 132 made of Ag with a thickness of 9 nm and a second oxide layer 133 made of ITO with a thickness of 20 nm. The optoelectronic foil thus obtained was subjected to tests involving a measurement of surface resistance by means of a four-point probe, a WVTR permeability measurement by means of a calcium test (measurement conditions RH=40%, T = 25°C) and measurement of light transmission in the visible spectrum using a UV-Vis spectrophotometer. The tests conducted yielded a surface resistance of the conductive layer 13 of 12 Ω/□, a WVTR permeability rate of less than 5*10⁻⁴ g/m² per day and light transmission in the visible spectrum in the range of 67-80%.

## Claims

1. An optoelectronic foil comprising a substrate (11) and a conductive layer (13) comprising at least one metal layer (132), wherein:
between the conductive layer (13) and the substrate (11), the foil (10) comprises a barrier layer (12) comprising at least one material selected from the group consisting of silicon oxides (SiOₓ), aluminium oxides (Al₂O₃, AlOₓN_{y}), titanium oxides (TiOₓ), silicon oxynitrides SiON, silicon nitrides (Si₃N₄, SiNₓ), organic silicon compounds (SiCₓH_{y}), zirconium oxide (Zr02), hafnium oxide (HfO₂), chromium oxides (CrO, Cr₂O₃, CrO₂, CrO₃, CrO₅) and parylene,
**characterized in that** the conductive layer (13) further comprises n oxide layers (131, 133) and n-1 metal layers (132), wherein the layers (131, 133, 132) are stacked one on the other, so that each metal layer (132) separates two adjacent oxide layers (132, 133) forming a sandwich structure, wherein n is a natural number not less than 2,
wherein each oxide layer (131, 133) is made of at least one oxide selected from the group consisting of: ZnO, AZO (aluminium zinc oxide), SnO₂, IZO (indium zinc oxide), FTO (fluorine tin oxide), ZTO (tin zinc oxide), ITO (tin indium oxide), GZO (zinc gallium oxide), GIO (indium gallium oxide), In₂O₃, Sb:SnO₂, IO:H (hydrogen indium oxide), CdO, Zn₂SnO₄, ZnSnO₃, Zn₂In2O₅, NiOₓ, NiOₓ:Li, TiOx, ZnS, ZnSe, Te₂O₃, MoOₓ, V₂O₅ and WO₃,
and wherein at least one of the oxide layers (131, 133) is:
- either a monolayer structure
- or a multi-layer structure consisting of at least two sublayers stacked one on the other within the oxide layer (131, 133) and wherein one of the sublayers is made of a different material than another sublayer.

2. The optoelectronic foil according to claim 1 **characterised in that** the barrier layer (12) is a monolayer structure.

3. The optoelectronic foil according to claim 1 , **characterised in that** the barrier layer (12) is a multi-layer structure consisting of at least two sublayers stacked one on the other within the barrier layer (12) and wherein one of the sublayers is made of a different material than another sublayer.

4. The optoelectronic foil according to any of the claims 1 to 3, **characterised in that** the substrate (1 1 ) is made of at least one plastic selected from the group consisting of: polyethylene terephthalate (PET), polyethylene naphthalene (PEN), polyethylene (PE), polypropylene (PP), polyethersulfone (PES), polyimide (PI), polystyrene (PS), ethylene/tetrafluoroethylene (ETFE) and parylene.

5. The optoelectronic foil according to claim 4, **characterised in that** the substrate (11 ) is doped with inorganic nanocomposites.

6. The optoelectronic foil according to any of the claims 1 to 5, **characterised in that** the metal layer (132) is made of a material selected from the group consisting of: Al, Ti, Ni, Cr, Au, Mg, Ta, Ge, Ag, Cu, Zr, Pt and W.

7. The optoelectronic foil according to any of the claims 1 to 6, **characterised in that** the conductive layer (13), comprises n oxide layers (131, 133) and n-1 metal layers (132) arranged alternately between adjacent oxide layers (131, 133).

8. A method for manufacturing the optoelectronic foil of claim 1 comprising the steps of:
- cleaning and activating a selected surface of the substrate onto which a barrier layer (12) is to be deposited,
- forming the barrier layer (12) on said cleaned and activated substrate (11),
- and, after forming the barrier layer (12), forming a conductive layer (13) comprising deposition of at least one metal layer (132) wherein
- the step of forming the barrier layer (12) comprises depositing of at least one material selected from the group consisting of silicon oxides (SiOₓ), aluminium oxides (Al₂O₃, AlOₓN_{y}), titanium oxides (TiOₓ), silicon oxynitrides SiON, silicon nitrides (Si₃N₄, SiNₓ), organic silicon compounds (SiCₓH_{y}), zirconium oxide (ZrO₂), hafnium oxide (HfO₂), chromium oxides (CrO, Cr₂O₃, CrO₂, CrO₃, CrOs) and parylene,
**characterized in that**
- the step of forming the conductive layer (13) further comprises depositing of at least two adjacent metal oxide layers (131, 133) each comprising at least one oxide selected from the group consisting of: ZnO, AZO (aluminum zinc oxide), SnO2, IZO (indium zinc oxide), FTO (fluorine tin oxide), ZTO (tin zinc oxide), ITO (tin indium oxide), GZO (zinc gallium oxide), GIO (indium gallium oxide), In2O3, Sb:SnO2, IO:H (hydrogen indium oxide), CdO, Zn2SnO4, ZnSnO3, Zn2ln2O5, NiOx, NiOx:Li, TiOx, ZnS, ZnSe, Te2O3, MoOx, V2O5 and WO3, and wherein depositing of the metal layer (132) comprises depositing of a single layer of metal selected from the group consisting of: Al, Ti, Ni, Cr, Au, Mg, Ta, Ge, Ag, Cu, Zr, Pt and W,
wherein forming the conductive layer (13) comprises forming on the barrier layer (12) consecutively: the first oxide layer (131), the single metal layer (132) and the second oxide layer (133).

9. The method according to claim 8, **characterised in that** the barrier layer (12) is formed by depositing one layer of material onto the substrate (11) to form a barrier layer (12) having a monolayer structure.

10. The method according to claim 8 or 9, **characterised in that** the barrier layer (12) is formed by depositing at least two sublayers of different material onto the substrate (11) to form the barrier layer (12) having a multi-layer structure.

11. The method according to any of the claims 8 to 10, **characterised in that** the conductive layer (13) is formed so that on the barrier layer (12) there are individually formed one on another, with the alternating arrangement of oxide layers (131 , 133) and metal layers (132), n oxide layers (131, 133) and n-1 metal layers (132), where n is a natural number.

12. The method according to any of the claims 8 to 11, **characterised in that** at least one oxide layer (131, 133) is formed by depositing one layer of oxide material to form an oxide layer (131, 133) having a monolayer structure.

13. The method according to any of the claims 8 to 11, **characterised in that** at least one oxide layer (131 , 133) is formed by depositing at least two oxide sublayers of different material to form an oxide layer (12) having a multi-layer structure.

14. The method according to any of the claims 8 to 13 , **characterised in that** the substrate (11) is cleaned and activated using at least one technique selected from the group consisting of: plasma treatment, corona discharge treatment, carbon dioxide treatment, ultraviolet radiation and ozone treatment, and cleaning with solvents selected from the group consisting of acetone, isopropanol, water, mixture of acetone and water and mixture of isopropanol and water.

15. The method according to any of the claims 8 to 14, **characterised in that** the barrier layer (12) and the conductive layer (13) are independently deposited onto the substrate (11) using at least one technique selected from the group consisting of atomic layer deposition (ALD), magnetron sputtering, electron-beam sputtering technique and thermal evaporation technique.

## Patentansprüche

1. Optoelektronische Folie, umfassend ein Substrat (11) und eine leitende Schicht (13), die mindestens eine Metallschicht (132) umfasst, wobei:
die Folie (10) zwischen der leitenden Schicht (13) und dem Substrat (11) eine Barriereschicht (12) umfasst, die mindestens ein Material umfasst, das aus der Gruppe ausgewählt ist, die aus Siliciumoxiden (SiOₓ), Aluminiumoxiden (Al₂O₃, AlOₓN_{y}), Titanoxiden (TiOₓ), Siliciumoxinitriden SiON, Siliciumnitriden (Si₃N₄, SiNₓ), organischen Siliciumverbindungen (SiCₓH_{y}), Zirkonoxid (Zr02), Hafniumoxid (HfO₂), Chromoxiden (CrO, Cr₂O₃, CrO₂, CrO₃, CrO₅) und Parylen besteht,
**dadurch gekennzeichnet, dass** die leitende Schicht (13) ferner n Oxidschichten (131, 133) und n-1 Metallschichten (132) umfasst, wobei die Schichten (131, 133, 132) übereinander gestapelt sind, sodass jede Metallschicht (132) zwei benachbarte Oxidschichten (132, 133) trennt, wodurch eine Sandwichstruktur gebildet wird, wobei n eine natürliche Zahl ist, die nicht kleiner als 2 ist,
wobei jede Oxidschicht (131, 133) aus mindestens einem Oxid aufgebaut ist, das aus der Gruppe ausgewählt ist, die aus Folgendem besteht: ZnO, AZO (Aluminiumzinkoxid), SnO₂, IZO (Indiumzinkoxid), FTO (Fluorzinnoxid), ZTO (Zinnzinkoxid), ITO (Zinnindiumoxid), GZO (Zinkgalliumoxid), GIO (Indiumgalliumoxid), In₂O₃, Sb:SnO₂, IO:H (Wasserstoffindiumoxid), CdO, Zn₂SnO₄, ZnSnO₃, Zn₂In2O₅, NiOₓ, NiOₓ:Li, TiOx, ZnS, ZnSe, Te₂O₃, MoOₓ, V₂O₅ und WO₃,
und wobei mindestens eine der Oxidschichten (131, 133) Folgendes ist:
- entweder eine einschichtige Struktur
- oder eine mehrschichtige Struktur, die aus mindestens zwei übereinander gestapelten Teilschichten innerhalb der Oxidschicht (131, 133) besteht und wobei eine der Teilschichten aus einem anderen Material als eine andere Teilschicht aufgebaut ist.

2. Optoelektronische Folie nach Anspruch 1, **dadurch gekennzeichnet, dass** die Barriereschicht (12) eine einschichtige Struktur ist.

3. Optoelektronische Folie nach Anspruch 1, **dadurch gekennzeichnet, dass** die Barriereschicht (12) eine mehrschichtige Struktur ist, die aus mindestens zwei übereinander gestapelten Teilschichten innerhalb der Barriereschicht (12) besteht und wobei eine der Teilschichten aus einem anderen Material als eine andere Teilschicht aufgebaut ist.

4. Optoelektronische Folie nach einem der Ansprüche 1 bis 3, **dadurch gekennzeichnet, dass** das Substrat (11) aus mindestens einem Kunststoff aufgebaut ist, der aus der Gruppe ausgewählt ist, die aus Folgendem besteht: Polyethylenterephthalat (PET), Polyethylennaphthalen (PEN), Polyethylen (PE), Polypropylen (PP), Polyethersulfon (PES), Polyimid (PI), Polystyrol (PS), Ethylen/Tetrafluorethylen (ETFE) und Parylen.

5. Optoelektronische Folie nach Anspruch 4, **dadurch gekennzeichnet, dass** das Substrat (11) mit anorganischen Nanokompositen dotiert ist.

6. Optoelektronische Folie nach einem der Ansprüche 1 bis 5, **dadurch gekennzeichnet, dass** die Metallschicht (132) aus einem Material aufgebaut ist, das aus der Gruppe ausgewählt ist, die aus Folgendem besteht: Al, Ti, Ni, Cr, Au, Mg, Ta, Ge, Ag, Cu, Zr, Pt und W.

7. Optoelektronische Folie nach einem der Ansprüche 1 bis 6, **dadurch gekennzeichnet, dass** die leitende Schicht (13) n Oxidschichten (131, 133) und n-1 Metallschichten (132) umfasst, die abwechselnd zwischen benachbarten Oxidschichten (131, 133) angeordnet sind.

8. Verfahren zum Herstellen der optoelektronischen Folie nach Anspruch 1, umfassend die folgenden Schritte:
- Reinigen und Aktivieren einer ausgewählten Oberfläche des Substrats, auf der eine Barriereschicht (12) abzuscheiden ist,
- Bilden der Barriereschicht (12) auf dem gereinigten und aktivierten Substrat (11),
- und nach dem Bilden der Barriereschicht (12) Bilden einer leitenden Schicht (13), umfassend eine Abscheidung von mindestens einer Metallschicht (132), wobei
- der Schritt des Bildens der Barriereschicht (12) ein Abscheiden von mindestens einem Material umfasst, das aus der Gruppe ausgewählt ist, die aus Siliciumoxiden (SiOₓ), Aluminiumoxiden (Al₂O₃, AlOₓN_{y}), Titanoxiden (TiOₓ), Siliciumoxinitriden SiON, Siliciumnitriden (Si₃N₄, SiNₓ), organischen Siliciumverbindungen (SiCₓH_{y}), Zirkonoxid (ZrO₂), Hafniumoxid (HfO₂), Chromoxiden (CrO, Cr₂O₃, CrO₂, CrO₃, CrO₅) und Parylen besteht,
**dadurch gekennzeichnet, dass**
- der Schritt des Bildens der leitenden Schicht (13) ferner Abscheiden von mindestens zwei angrenzenden Metalloxidschichten (131, 133) umfasst, die jeweils mindestens ein Oxid umfassen, das aus der Gruppe ausgewählt ist, die aus Folgendem besteht: ZnO, AZO (Aluminiumzinkoxid), SnO2, IZO (Indiumzinkoxid), FTO (Fluorzinnoxid), ZTO (Zinnzinkoxid), ITO (Zinnindiumoxid), GZO (Zinkgalliumoxid), GIO (Indiumgalliumoxid), In203, Sb:SnO2, IO:H (Wasserstoffindiumoxid), CdO, Zn2SnO4, ZnSnO3, Zn21n205, NiOx, NiOx:Li, TiOx, ZnS, ZnSe, Te2O3, MoOx, V2O5 und WO3, und wobei das Abscheiden der Metallschicht (132) Abscheiden einer einzelnen Schicht aus Metall umfasst, das aus der Gruppe ausgewählt ist, die aus Folgendem besteht: Al, Ti, Ni, Cr, Au, Mg, Ta, Ge, Ag, Cu, Zr, Pt und W,
wobei das Bilden der leitenden Schicht (13) Bilden von Folgendem nacheinander auf der Barriereschicht (12) umfasst: die erste Oxidschicht (131), die einzelne Metallschicht (132) und die zweite Oxidschicht (133).

9. Verfahren nach Anspruch 8, **dadurch gekennzeichnet, dass** die Barriereschicht (12) durch Abscheiden einer Materialschicht auf dem Substrat (11) gebildet wird, um eine Barriereschicht (12) zu bilden, die eine einschichtige Struktur aufweist.

10. Verfahren nach Anspruch 8 oder 9, **dadurch gekennzeichnet, dass** die Barriereschicht (12) durch Abscheiden von mindestens zwei Teilschichten aus unterschiedlichem Material auf dem Substrat (11) gebildet wird, um die Barriereschicht (12) zu bilden, die eine mehrschichtige Struktur aufweist.

11. Verfahren nach einem der Ansprüche 8 bis 10, **dadurch gekennzeichnet, dass** die leitende Schicht (13) so gebildet wird, dass auf der Barriereschicht (12) mit der abwechselnden Anordnung von Oxidschichten (131 , 133) und Metallschichten (132) einzeln übereinander gebildete n Oxidschichten (131, 133) und n-1 Metallschichten (132) vorhanden sind, wobei n eine natürliche Zahl ist.

12. Verfahren nach einem der Ansprüche 8 bis 11, **dadurch gekennzeichnet, dass** mindestens eine Oxidschicht (131, 133) durch Abscheiden einer Schicht aus Oxidmaterial gebildet wird, um eine Oxidschicht (131, 133) zu bilden, die eine einschichtige Struktur aufweist.

13. Verfahren nach einem der Ansprüche 8 bis 11, **dadurch gekennzeichnet, dass** mindestens eine Oxidschicht (131 , 133) durch Abscheiden von mindestens zwei Oxidteilschichten aus unterschiedlichem Material gebildet wird, um eine Oxidschicht (12) zu bilden, die eine mehrschichtige Struktur aufweist.

14. Verfahren nach einem der Ansprüche 8 bis 13, **dadurch gekennzeichnet, dass** das Substrat (11) unter Verwendung mindestens einer Technik gereinigt und aktiviert wird, die aus der Gruppe ausgewählt ist, die aus Folgendem besteht: Plasmabehandlung, Koronaentladungsbehandlung, Kohlendioxidbehandlung, ultraviolette Strahlung und Ozonbehandlung und Reinigung mit Lösungsmitteln, die aus der Gruppe ausgewählt sind, die aus Aceton, Isopropanol, Wasser, einer Mischung aus Aceton und Wasser und einer Mischung aus Isopropanol und Wasser besteht.

15. Verfahren nach einem der Ansprüche 8 bis 14, **dadurch gekennzeichnet, dass** die Barriereschicht (12) und die leitende Schicht (13) unabhängig voneinander auf dem Substrat (11) unter Verwendung mindestens einer Technik abgeschieden werden, die aus der Gruppe ausgewählt ist, die aus Atomlagenabscheidung (ALD), Magnetronsputtern, Elektronenstrahlsputtertechnik und thermischer Verdampfungstechnik besteht.

## Revendications

1. Feuille optoélectronique comprenant un substrat (11) et une couche conductrice (13) comprenant au moins une couche métallique (132), dans laquelle :
entre la couche conductrice (13) et le substrat (11), la feuille (10) comprend une couche barrière (12) comprenant au moins un matériau choisi dans le groupe constitué des oxydes de silicium (SiOₓ), oxydes d'aluminium (Al₂O₃, AlOₓN_{y}) , oxydes de titane (TiOₓ), oxynitrures de silicium SiON, nitrures de silicium (Si₃N₄, SiNₓ), composés organiques du silicium (SiCₓH_{y}), oxyde de zirconium (ZrO₂), oxyde d'hafnium (HfO₂), oxydes de chrome (CrO, Cr₂O₃, CrO₂, CrO₃, CrO₅) et parylène,
**caractérisée en ce que** la couche conductrice (13) comprend en outre n couches d'oxyde (131, 133) et n-1 couches métalliques (132), dans laquelle les couches (131, 133, 132) sont empilées les unes sur les autres, de sorte que chaque couche métallique (132) sépare deux couches d'oxyde adjacentes (132, 133) formant une structure sandwich, dans laquelle n est un nombre naturel non inférieur à 2,
dans laquelle chaque couche d'oxyde (131, 133) est constituée d'au moins un oxyde sélectionné dans le groupe constitué de : ZnO, AZO (oxyde d'aluminium-zinc), SnO₂, IZO (oxyde d'indium-zinc), FTO (oxyde de fluor-étain), ZTO (oxyde d'étain-zinc), ITO (oxyde d'étain-indium), GZO (oxyde de zinc-gallium), GIO (oxyde d'indium-gallium), In₂O₃, Sb:SnO₂, IO:H (oxyde d'hydrogène-indium), CdO, Zn₂SnO₄, ZnSnO₃, Zn₂ln2O₅, NiOₓ, NiOₓ:Li, TiOx, ZnS, ZnSe, Te₂O₃, MoOₓ, V₂O₅ et WO₃,
et dans laquelle au moins une des couches d'oxyde (131, 133) est :
- soit une structure monocouche
- soit une structure multicouche constituée d'au moins deux sous-couches empilées l'une sur l'autre au sein de la couche d'oxyde (131, 133) et dans laquelle l'une des sous-couches est constituée d'un matériau différent d'une autre sous-couche.

2. Feuille optoélectronique selon la revendication 1, **caractérisée en ce que** la couche barrière (12) est une structure monocouche.

3. Feuille optoélectronique selon la revendication 1, **caractérisée en ce que** la couche barrière (12) est une structure multicouche constituée d'au moins deux sous-couches empilées l'une sur l'autre au sein de la couche barrière (12) et dans laquelle l'une des sous-couches est constituée d'un matériau différent d'une autre sous-couche.

4. Feuille optoélectronique selon l'une quelconque des revendications 1 à 3, **caractérisée en ce que** le substrat (11) est constitué d'au moins un plastique choisi dans le groupe constitué de : polyéthylène téréphtalate (PET), polyéthylène naphtalène (PEN), polyéthylène (PE), polypropylène (PP), polyéthersulfone (PES), polyimide (PI), polystyrène (PS), éthylène/tétrafluoroéthylène (ETFE) et parylène.

5. Feuille optoélectronique selon la revendication 4, **caractérisée en ce que** le substrat (11) est dopé avec des nanocomposites inorganiques.

6. Feuille optoélectronique selon l'une quelconque des revendications 1 à 5, **caractérisée en ce que** la couche métallique (132) est constituée d'un matériau choisi dans le groupe constitué de : Al, Ti, Ni, Cr, Au, Mg, Ta, Ge, Ag, Cu, Zr, Pt et W.

7. Feuille optoélectronique selon l'une quelconque des revendications 1 à 6, **caractérisée en ce que** la couche conductrice (13) comprend n couches d'oxyde (131, 133) et n-1 couches métalliques (132) disposées alternativement entre des couches d'oxyde adjacentes (131, 133).

8. Procédé de fabrication de la feuille optoélectronique selon la revendication 1, comprenant les étapes de :
- nettoyage et activation d'une surface sélectionnée du substrat sur laquelle une couche barrière (12) doit être déposée,
- formation de la couche barrière (12) sur ledit substrat nettoyé et activé (11),
- et, après formation de la couche barrière (12), formation d'une couche conductrice (13) comprenant le dépôt d'au moins une couche métallique (132), dans lequel
- l'étape de formation de la couche barrière (12) comprend le dépôt d'au moins un matériau choisi dans le groupe constitué des oxydes de silicium (SiOₓ), oxydes d'aluminium (Al₂O₃, AIOₓN_{y}), oxydes de titane (TiOₓ), oxynitrures de silicium SiON, nitrures de silicium (Si₃N₄, SiNₓ), composés organiques du silicium (SiCₓH_{y}), oxyde de zirconium (ZrO₂), oxyde d'hafnium (HfO₂), oxydes de chrome (CrO, Cr₂O₃, CrO₂, CrO₃, CrO₅) et parylène,
**caractérisé en ce que**
- l'étape de formation de la couche conductrice (13) comprend en outre le dépôt d'au moins deux couches d'oxyde métallique adjacentes (131, 133) comprenant chacune au moins un oxyde choisi dans le groupe constitué de : ZnO, AZO (oxyde d'aluminium-zinc), SnO2, IZO (oxyde d'indium-zinc), FTO (oxyde de fluor-étain), ZTO (oxyde d'étain-zinc), ITO (oxyde d'étain-indium), GZO (oxyde de zinc-gallium), GIO (oxyde d'indium-gallium), In203, Sb:SnO2, IO:H (oxyde d'hydrogène-indium), CdO, Zn2SnO4, ZnSnO3, Zn2ln2O5, NiOx, NiOx:Li, TiOx, ZnS, ZnSe, Te2O3, MoOx, V2O5 et WO3, et dans lequel le dépôt de la couche métallique (132) comprend le dépôt d'une couche unique de métal sélectionné dans le groupe constitué de : Al, Ti, Ni, Cr, Au, Mg, Ta, Ge, Ag, Cu, Zr, Pt et W,
dans lequel la formation de la couche conductrice (13) comprend la formation sur la couche barrière (12) de, consécutivement : la première couche d'oxyde (131), la couche métallique unique (132) et la deuxième couche d'oxyde (133).

9. Procédé selon la revendication 8, **caractérisé en ce que** la couche barrière (12) est formée par dépôt d'une couche de matériau sur le substrat (11) pour former une couche barrière (12) comportant une structure monocouche.

10. Procédé selon la revendication 8 ou 9, **caractérisé en ce que** la couche barrière (12) est formée par dépôt d'au moins deux sous-couches de matériau différent sur le substrat (11) pour former la couche barrière (12) comportant une structure multicouche.

11. Procédé selon l'une quelconque des revendications 8 à 10, **caractérisé en ce que** la couche conductrice (13) est formée de telle sorte que sur la couche barrière (12) soient formées individuellement les unes sur les autres, avec une disposition alternée des couches d'oxyde (131, 133) et des couches métalliques (132), n couches d'oxyde (131, 133) et n-1 couches métalliques (132), où n est un nombre naturel.

12. Procédé selon l'une quelconque des revendications 8 à 11, **caractérisé en ce qu'**au moins une couche d'oxyde (131, 133) est formée par dépôt d'une couche de matériau oxyde pour former une couche d'oxyde (131, 133) comportant une structure monocouche.

13. Procédé selon l'une quelconque des revendications 8 à 11, **caractérisé en ce qu'**au moins une couche d'oxyde (131, 133) est formée par dépôt d'au moins deux sous-couches d'oxyde de matériau différent pour former une couche d'oxyde (12) comportant une structure multicouche.

14. Procédé selon l'une quelconque des revendications 8 à 13, **caractérisé en ce que** le substrat (11) est nettoyé et activé en utilisant au moins une technique choisie dans le groupe constitué de : traitement au plasma, traitement par décharge corona, traitement au dioxyde de carbone, traitement par rayonnement ultraviolet et ozone, et nettoyage avec des solvants choisis dans le groupe constitué de l'acétone, isopropanol, eau, mélange d'acétone et d'eau et mélange d'isopropanol et d'eau.

15. Procédé selon l'une quelconque des revendications 8 à 14, **caractérisé en ce que** la couche barrière (12) et la couche conductrice (13) sont déposées indépendamment sur le substrat (11) en utilisant au moins une technique choisie dans le groupe constitué du dépôt de couches atomiques (ALD), pulvérisation magnétron, technique de pulvérisation par faisceau d'électrons et technique d'évaporation thermique.
